# EUROPEAN PATENT APPLICATION

(11) **EP 2 474 841 A1**
(43) Date of publication of application: **11.07.2012**
(21) Application number: 09848751.5
(22) Date of filing: 31.08.2009
(51) Int. Cl.: G01V 3/08

(54) **ELECTROSTATIC CAPACITY TYPE PROXIMITY SENSOR**

(71) Applicant: Nonogaki, Keiichi, Okazaki-shi, Aichi 444-0951 (JP)
(72) Inventor: Nonogaki, Keiichi, Okazaki-shi, Aichi 444-0951 (JP)
(74) Representative: Topf, Michael Klaus
(86) International application number: PCT/JP2009/065184
(87) International publication number: WO 2011/024306

(57) **Abstract**

A capacitive proximity sensor giving a long front detection range with less erroneous detection.

A capacitive proximity sensor detects an approach of an object such as a human body or so by its capacitance change. The capacitance in a capacity composed by a first electrode and a second electrode in the sensor varies according to the approach of the object in distance. The first electrode (1) is in a linear shape at a small surface area such as an electric wire. The second electrode (2) is in a planar shape at a large surface area such as a flat plate or a sheet. The first electrode (1) and the second electrode (2) are arranged in parallel at a separation. A front detection region in front of the capacitive proximity sensor is at a side where the first electrode (1) appears upon the second electrode (2).

A shield electrode (8) is placed behind the second electrode (2) face to face in parallel at a separation. The shield electrode (8) is grounded.

## Description

### Technical Field

The present invention relates to a sensor which detects an approach of an object such as a human body or so by a change of a capacitance, in particular to a capacitive proximity sensor with multifaceted electrodes.

### Background Art

A conventional capacitive proximity sensor uses a pair of two sheets of electrodes. The electrodes are originally flat plates facing each other in parallel. The pair of electrodes composes a capacitor of which electric filed lines emerge from one electrode and return into the other electrode. While an object such as a human body or so approaches to the electrodes, electric field lines out from the electrodes are deformed, and the capacitance formed by the electrodes changes. An approach of the object is detected by a change of the capacitance.

### Citation List

### Patent Literature

[PTL 1] Patent Literature 1: JP-A-2006-78422

### Summary of the Invention

### Technical Problem

### [Problem to be solved]

A capacitive proximity sensor is required to have a front detection range as long as possible to detect an object far apart from its electrodes in front of the sensor, but to have a rear detection range as short as possible to avoid unneeded detection in rear of the sensor.

### [Conceptions]

While a human body approaches to a pair of electrodes, electric field lines emerging from one of the electrodes do not return into the other electrode but to enter into the human body, which is virtually grounded with alternative electric filed. The approach of the human body has changed the capacitance between the pair of electrodes.
It is considered that the front detection range becomes longer, if larger number of the electric filed lines interconnecting between the pair of the electrodes expand to a farther extent in front of the electrodes.
Generally, both electrodes in pairs are plains identical in shape and size. Only a few electric filed lines swell out from the electrodes to the outside. To obtain a longer detection range, one of the pair of the electrodes shall be shaped in a line at a small surface area, and the other electrode shall be shaped in a plain as a plate, or a sheet at a large surface area.

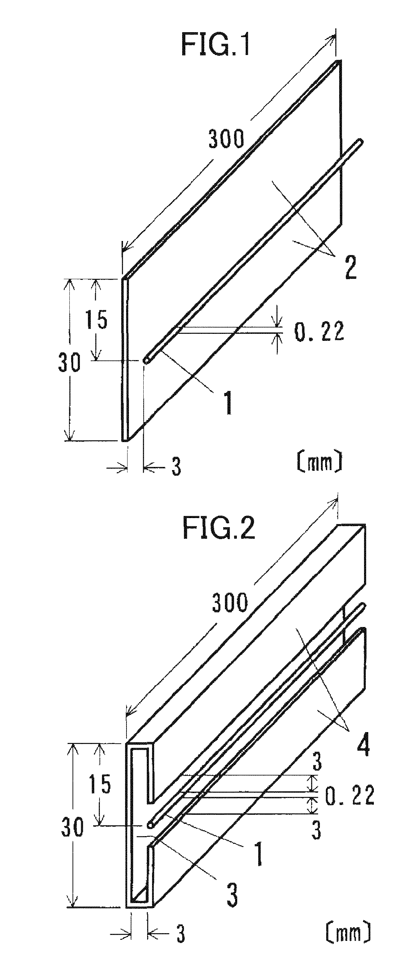

### [ExperimentA (Refer to FIG.1, 2, 3, 4 and 5.)]

A linear electrode and a planar electrode are applied to a capacitive proximity sensor in an experiment.

### 1) Electrodes (Refer to FIG.1, 2 and 3.)

A pair of electrodes of example 1 shown in FIG.1 is composed of a linear electrode 1 which is an electric wire, 0.22 mm in a diameter and 300 mm long, and a planar electrode 2 which is a flat sheet or a plate in a tape-like or a rectangular shape, 30 mm wide and 300 mm long. The linear electrode 1 and the planar electrode 2 are placed each other in parallel in a same way to the same extent from one end to the other end lengthwise. Besides, the linear electrode 1 is widthwise positioned at a center of the planar electrode 2 at 3 mm separation. A front side of the pair of electrodes is where the linear electrode 1 appears upon the planar electrode 2. The front detection region is at the front side. A rear side of the pair of electrodes is where the linear electrode 1 hides behind the planar electrode 2.

A pair of electrodes of example 2 shown in FIG.2 is composed of a linear electrode 1, which is an electric wire, same as the example 1, and a planar electrode 2, which is formed in a channel that both sides of a widened flat plate are lengthwise folded backside up. In details, the planner electrode 2 is composed of a rear panel 3, an upper panel, a lower panel and two front panels 4. The rear panel 3, which is the same size and shape as the planar electrode 2 of the example 1 is linked to the two front panels 4 through the upper panel and the rear panel respectively. The linear electrode 1 is positioned at the center of the rear panel 3 as same as the linear electrode 1 against the planar electrode 2 shown in the example 1. The two front panels 4 are parallel to the rear panel 3, and placed at both upper and lower sides of the linear electrode 1 at 3 mm separation respectively. The planar electrode 2 involves the rear panel 3 and the two front panels 4. A front side is where the linear electrode 1 appears among the two front panels 4 above the rear panel 3. A front detection region is at the front side. A rear side is where the linear electrode 1 hides behind the rear panel 3.

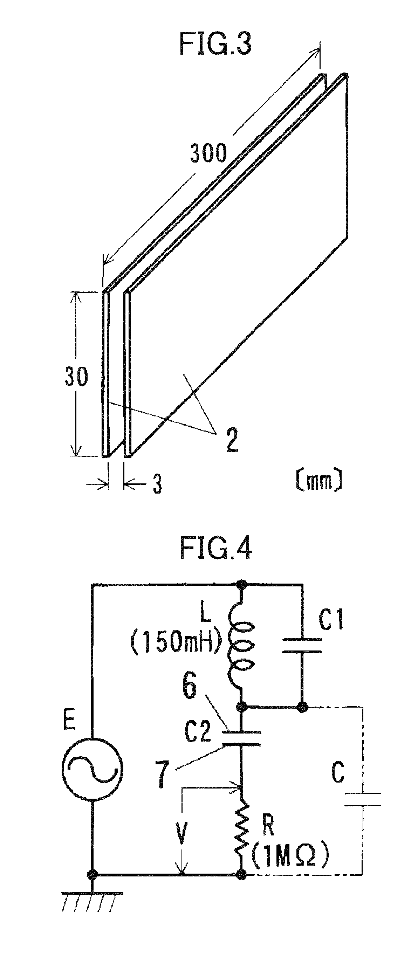

A pair of electrodes of a conventional example shown in FIG.3, uses two sheets of planar electrodes. Both are same as the planar electrode 2 used in example 1. The electrodes are in parallel at 3 mm separation each other.

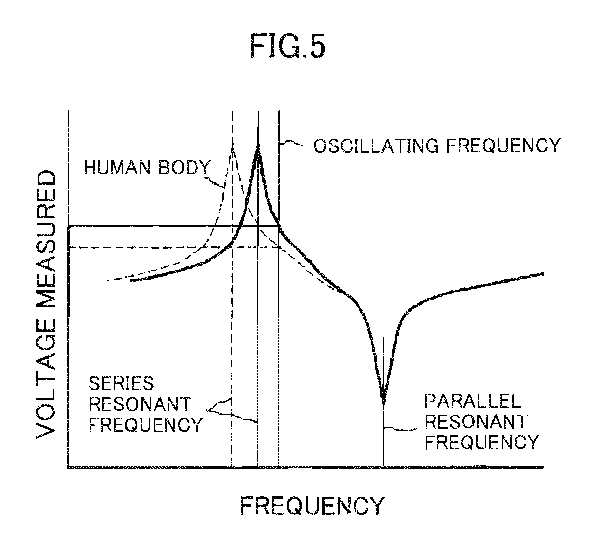

### 2) Electric circuit (Refers to FIG.4 and 5.)

Several kinds of electric circuits, able to pick up a change of a capacitance, are applicable, but the present invention uses a series resonant circuit. The circuit shown in FIG.4 is constructed by an oscillator E, a coil L carrying a wire winding capacitance C1, a capacitor C2 composed of an electrode 6 and an electrode 7, and a resistor R. These are linked in series. The coil L and the wire winding capacitance C1 configure a parallel resonant circuit. The coil L and the capacitor C2 configure the series resonant circuit. A connection point between the oscillator E and the resistor R is grounded. A voltage V between both terminals of the resistor R is measured. The voltage V measured against frequency of the oscillator E is expressed in a bold solid curve in FIG. 5. The series resonant frequency is lower than the parallel resonant frequency.

While an object such as a human body, which is virtually grounded with alternative electric filed, is approaching to the electrodes 6 and 7, the capacitance of the capacitor C2 decreases on one hand, but on the other hand the human body develops a capacitor C implicitly connected in parallel to a series link of the capacitor C2 and the resistor R. The human-body developed capacitance of the capacitor C is several times larger than the lost capacitance of the capacitor C2. For example, the developed capacitance of the capacitor C is from 2 to 3 pF while the lost capacitance of the capacitor C2 is around 0.7 pF. The series resonant frequency lowers as the series resonant circuit gains the capacitance in total by an approach of the human body. In this case, the voltage V measured against frequency of the oscillator E is expressed in a dotted curve in FIG. 5. A peak at the series resonant frequency shifts to the lower frequency side by the approach.

The oscillator E generating a sinusoidal wave is set to a little higher frequency than the series resonant frequency. While no object such as a human body is around, an amplitude of the oscillator E is adjusted to have the voltage V set in 8V regarded as an initial state. While a human hand is approaching to the electrodes 6 and 7, the voltage decreases from the initial state of 8V.

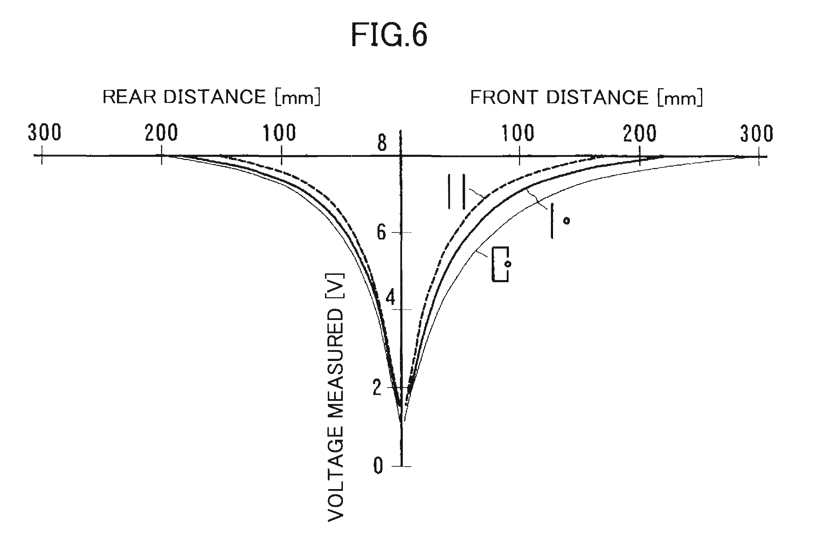

### 3) Experiment B (Refers to FIG.6.)

With the pair of electrodes of the example 1, the linear electrode 1 corresponding to the electrode 7 is connected to the resistor R, and the planar electrode 2 corresponding to the electrode 6 is connected to the coil L. While no human body is around, the oscillating frequency is set to 54 kHz, and an oscillating amplitude is set to 0.5 mV to have the voltage V set in 8V as the initial state. A human-hand object is positioned at every distance away from the linear electrode 1 in the front detection region, and how much the voltage V drops from the initial state of 8V is measured. Also, the object is positioned at every distance away from the planar electrode 2 in the rear detection region, and how much the voltage V drops from the initial state of 8V is measured.

The result is shown in a bold solid curve in FIG.6. While the human hand is closing to the linear electrode 1 in the front detection region, the voltage V starts to drop from the initial state of 8V when the human hand is more than 200 mm away from the linear electrode 1. The human hand becomes detected. While the human hand continues to approach to the linear electrode 1, the voltage V drops exponentially. In addition, in the rear detection region while the human hand is closing to the planar electrode 2, the voltage V starts to drop from the initial state of 8V when the human hand is less than 200mm away from the planar electrode 2. The human hand becomes detected. While the human hand continues to approach to the planar electrode 2, the voltage V drops exponentially. The front detection region where the linear electrode 1 appears is longer in range than the rear detection region where the planar electrode 2 appears.

Alternatively, the linear electrode 1 is able to correspond to the electrode 6 and the planar electrode 2 to the electrode 7. The oscillating frequency is set to 57 KHz, and the oscillating amplitude is set to 0.4 mV with this combination to have the voltage set in 8V as the initial state. Instead of the different setup, the result is the same as the previous experiment.

With the pair of electrodes of the example 2, the linear electrode 1 corresponding to the electrode 7 is connected to the resistor R, and the planar electrode 3 and 4 corresponding to the electrode 6 is connected to the coil L. The oscillating frequency is set to 55 kHz, and oscillating amplitude is set to 0.4 mV to have the voltage V set in 8V as the initial state while no human body is around. The result is shown in a thin solid curve in FIG.6. While the human hand is closing to the linear electrode 1 in the front detection region, the voltage V starts to drop from the initial state of 8V when the human hand is around 300 mm away from the linear electrode 1. The human hand becomes detected. While the human hand continues to approach to the linear electrode 1, the voltage V drops exponentially. In addition, in the rear detection region while the human hand is closing to the planar electrode 2, the voltage V starts to drop from the initial state of 8V when the human hand is around 200mm away from the planar electrode 2.While the human hand continues to approach to the planar electrode 2, the voltage V drops exponentially. The front detection region where the linear electrode 1 appears is much longer in range than the rear detection region where the rear panel 3 of the planar electrode 3 and 4 appears. The front detection region of the example 2 is much longer in range than the front detection region of the example 1.

Alternatively, the linear electrode 1 is able to correspond to the electrode 6, and the planar electrode 3 and 4 to the electrode 7. The oscillating frequency and the oscillating amplitude are set to the same levels as the previous experiment with this combination to have the voltage set in 8V as the initial state. The result is the same as the previous experiment as well.

With the pair of electrodes of the conventional example, one planar electrode 2 corresponds to the electrode 7, and the other planar electrode 2 corresponds to the electrode 6. The oscillating frequency is set to 63 kHz, and oscillating amplitude is set to 0.6 mV to have the voltage V set in 8V as the initial state. The result is shown in a dotted curve in FIG.6. Both the front detection region and the rear detection region span from 160 mm to 170 mm in range. The front detection region of the conventional example is shorter in range than the front detection region of the example 1 or the example 2. Example 1 and 2 give longer front detection regions.

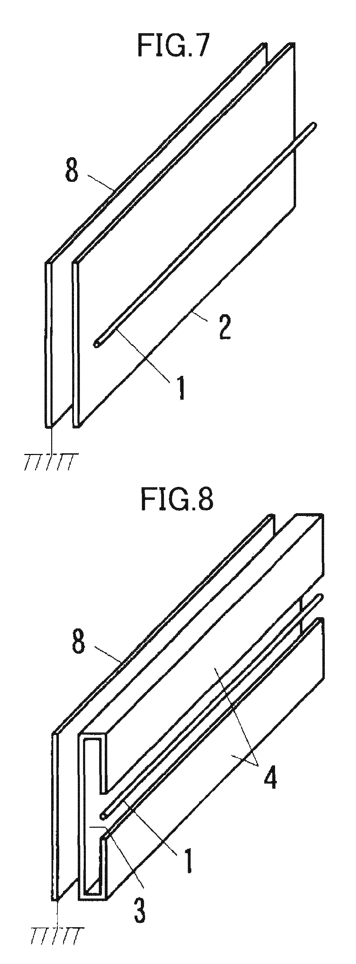

### [Shield electrode (Refers to FIG.7, 8 and 9)]

With the example 1 and 2, the rear detection region is shorter in range than the front detection region. It is not sufficient to avoid unneeded detection in rear. A shield electrode is therefore placed to shorten the rear detection region. The example 1 has the shield electrode 8 placed in parallel behind the planar electrode 2 at a separation face to face in FIG.7. The shield electrode is a tape-like, or a rectangular flat plate, or a sheet. The example 2 has the shield electrode 8 placed in parallel behind the planar electrode 3 and 4 at a separation face to face in FIG.8. The shield electrode 8 is grounded.

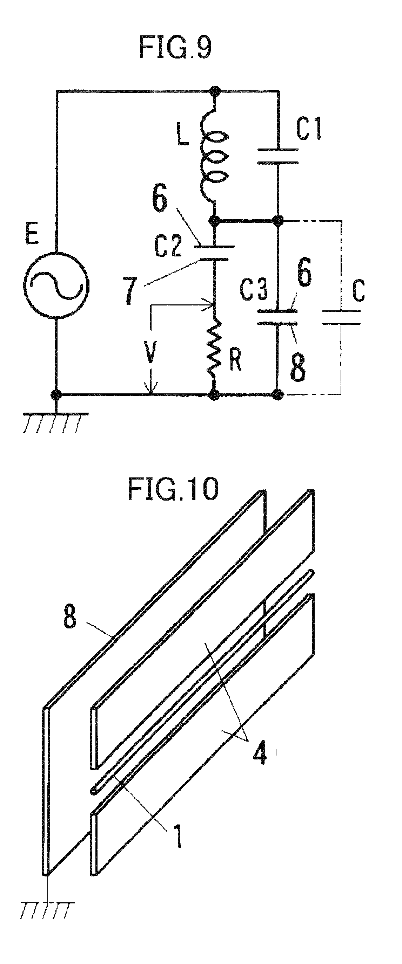

The example 1 has the capacitor C2 composed of the electrode 7 as the linear electrode 1 and the electrode 6 as the planar electrode 2. In addition, a capacitor C3 is composed of the electrode 6 as the planer electrode 2 and the shield electrode 8. The example 2 has the capacitor C2 composed of the electrode 7 as the linear electrode 1 and the electrode 6 as the planar electrode 3 and 4. In addition, the capacitor C3 is composed of the electrode 6 as the planar electrode 3 and 4, and the shield electrode 8. The series resonant circuit shown in FIG. 4 is replaced by the series resonant circuit shown in FIG. 9. The capacitor C3 is coupled in parallel to the series link of the capacitor C2 and the resistor R shown in FIG.9.

The rear detection region of the example 1 or 2 equipped with the shield electrode 8 is short in range.

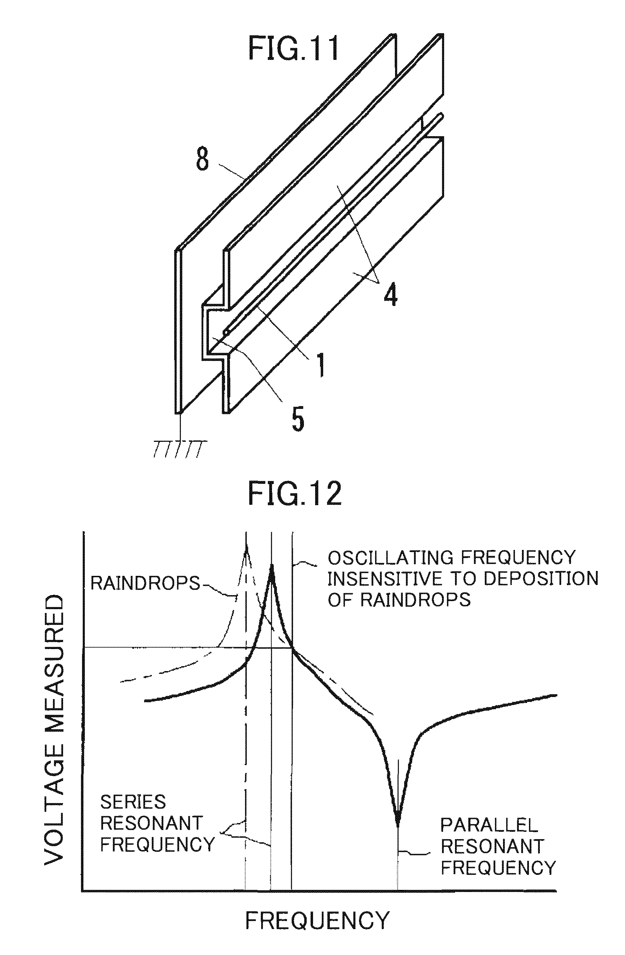

### [Other examples of a pair of electrodes (Refer to FIG.10 and 11)]

The planar electrode 2 of the example 2 is modified in shape into the example 3. Only the two flat front panels 4 comprise the planar electrode 2 of the example 3 as shown in FIG. 10. The rear panel 3, the upper panel, and the lower panel of the planar electrode 2 of the example 2 are removed. A pair of electrodes of the example 3 is composed of the linear electrode 1 and the two flat front panels 4 of the planar electrode 2, which are easier to produce than the channel planar electrode of the example 2.

The planar electrode of the example 3 is modified in shape into the example 4. The two front panels 4 and a groove panel 5 comprise a channel planar electrode of the example 4. The groove panel 5 is joined to the two front panels 4 at both sides respectively as shown in FIG. 11. The groove panel 5 is closer to the shield electrode 8. A pair of electrodes of the example 4 is composed of the linear electrode 1 and the channel planar electrode 4 and 5, which are easier to produce than the channel planar electrode of the example 2.

### [Erroneous detection with raindrops (Refers to FIG.9 and FIG.12)]

A capacitive proximity sensor equipped with a pair of electrodes may be used outdoors. If that is the case, raindrops or so attach to a vicinity of the electrodes 6 and 7, which is embedded in a sensing head of the sensor. It is desired that the sensor is not affected by deposition of raindrops.

The capacitance of the capacitor C2 between the pair of electrodes 6 and 7 shown in FIG. 9 largely increases when raindrops or so rest on much closer vicinities of the electrodes 6 and 7, explicitly as close as 1 mm separation or less. Raindrops work as dielectric between the electrodes. The capacitance of the capacitor C3 between the electrode 6 and the shield electrode 8 does not change where they are not closely exposed to raindrops. Raindrops, which are not virtually grounded, do not constitute the capacitor C. Instead, the human body, which is virtually grounded with alternative electric filed, constitutes the capacitor C.

The capacitance of the capacitor C2 increases when raindrops, which are not virtually grounded, approach closely to the electrode 6 and 7. The increase of the capacitance of the capacitor C2 lowers the series resonant frequency of the series resonant circuit. At the same time, an impedance of the capacitor C2 decreases. The decrease of the impedance of the capacitor C2 raises the current flowing through the series link of the capacitor C2 and the resistor R. The voltage between the terminals of the resister R increases. The peak at the series resonant frequency, therefore, shifts to the lower frequency side and the higher voltage place, as expressed in a dotted curve shown in FIG. 12. The FIG.12 depicts the voltage V measured against frequency of the oscillator E. The capacitor C3 maintains its impedance.

The solid curve, expressing the initial condition no raindrops close to the electrodes, and the dotted curve, expressing the condition raindrops close to the electrodes, intersect each other at a frequency, a little higher than the series resonant frequency of the solid curve, as shown in FIG. 12. At the frequency that the solid curve and the dotted curve intersect, the voltage V keeps the same level or changes only a little even though raindrops are close to the electrodes. There is the oscillating frequency insensitive to deposition of raindrops. The sensor becomes not to generate any erroneous signal against deposition of raindrops by the oscillating frequency set to the frequency of the intersection.

The electrode 6 and the shield electrode 8 should have a construction to prevent raindrops from approaching to them around.

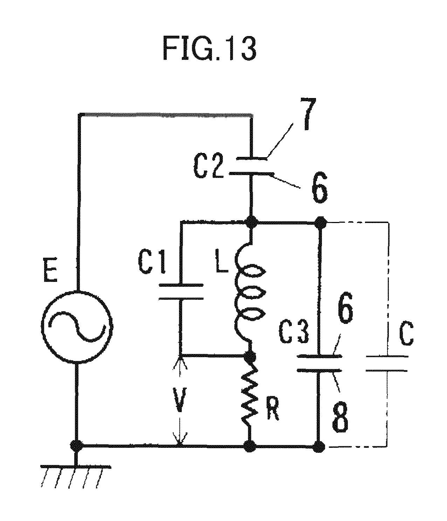

### [Other electrical circuit (Refers to FIG.13)]

The electrical circuit shown in FIG. 13 exchanges the coil L carrying the wire winding capacitance C1 for the capacitor C2 composed of the electrodes 6 and 7 in position shown in the electric circuit of FIG. 9. Both electric circuits are equivalent.

### Solution to Problem

1) A capacitive proximity sensor that detects an object such as a human body or so approaching to the sensor by a change of capacitance formed by between a first electrode and a second electrode, comprising:
   the first electrode being in a linear shape at a small surface area, and the second electrode being in a planar shape at a large surface area;
   the first linear electrode and the second planar electrode arranged in parallel at a separation; and
   a front detection region in front of the sensor being at a side where the first linear electrode appears upon the second planar electrode.
2) The capacitive proximity sensor according to claim 1, wherein the linear electrode is an electric wire; and
   the planar electrode is a flat plate, a folded profile folding a fiat plate or a bent profile bending a flat plate.
3) The capacitive proximity sensor according to claim 1 or 2, comprising a shield electrode facing to the planar electrode in parallel at a separation behind the planar electrode, and the shield electrode is grounded.
4) The capacitive proximity sensor according to claim 1, 2 or 3, comprising an electrical circuit including the capacitor composed of the linear electrode and the planar electrode, wherein the electric circuit changes a voltage or a current at a part of the circuit when the object approaches to the detecting region in front of the capacitive proximity sensor, and the voltage or the current is detected.
5) The capacitive proximity sensor according to claim 1, 2, 3 or 4 wherein the capacitor composed of the linear electrode and the planar electrode, a coil connected to the planar electrode, a resistor and an oscillator are connected to comprise a series resonant circuit;
   a voltage of the resistor at both ends or a current through the series resonant circuit is detected; and
   an oscillating frequency of the oscillator is set to a frequency, which is higher than a series resonant frequency, where the voltage or the current drops by decrease of the series resonant frequency when the object approaches to the detecting region in front of the capacitive proximity sensor, but the voltage or the current does not change or undergoes very little change by decrease of an impedance along with decrease of the series resonant frequency when non-detection objects such as raindrops etc. approach closely to the capacitive proximity sensor.

### Advantageous Effects of Invention

A capacitive proximity sensor obtains a long detection range in front of the sensor, but a short detection range in rear of the sensor without erroneous detection.

### Brief Description of the Drawings

[FIG.1] FIG.1 is a perspective view of the electrode of the capacitive proximity sensor of the example 1 of the present invention.
[FIG.2] FIG.2 is a perspective view of the electrodes of the example 2.
[FIG.3] FIG.3 is a perspective view of electrodes of the conventional example.
[FIG.4] FIG.4 is an electric circuit diagram of the capacitive proximity sensors used in the experiments.
[FIG.5] FIG.5 is a graph showing curves of the voltage measured against oscillating frequency with the electric circuit used in the experiment A.
[FIG.6] FIG.6 is a graph showing curves of the voltage measured against distances to the object in the experiment B.
[FIG.7] FIG.7 is a perspective view of the electrodes of the example 1 of the capacitive proximity sensor equipped with the shield electrode.
[FIG.8] FIG.8 is a perspective view of the electrodes of the example 2 of the capacitive proximity sensor equipped with the shield electrode.
[FIG.9] FIG.9 is an electric circuit diagram of the capacitive proximity sensors equipped with the shield electrodes.
[FIG.10] FIG.10 is a perspective view of the electrodes of an additional example equipped with the shield electrode.
[FIG.11] FIG.11 is a perspective view of the electrodes of a further additional example equipped with the shield electrode.
[FIG.12] FIG.12 is a graph showing the oscillating frequency insensitive to deposition of raindrops in the same manner as FIG.5.
[FIG.13] FIG.13 is the other electric circuit diagram of the capacitive proximity sensors equipped with the shield electrodes.
[FIG.14] FIG.14 is an electric circuit schematic of the capacitive proximity sensor of an embodiment.
[FIG.15] FIG.15 is a front view inside the case of the sensing head including electrodes of the capacitive proximity sensor of the embodiment.
[FIG.16] FIG.16 is an enlarged cross-section view of the sensing head including electrodes along line A-A of FIG.15.
[FIG.17] FIG.17 is an electric circuit diagram of the capacitive proximity sensor of the embodiment.

### Description of the Embodiments

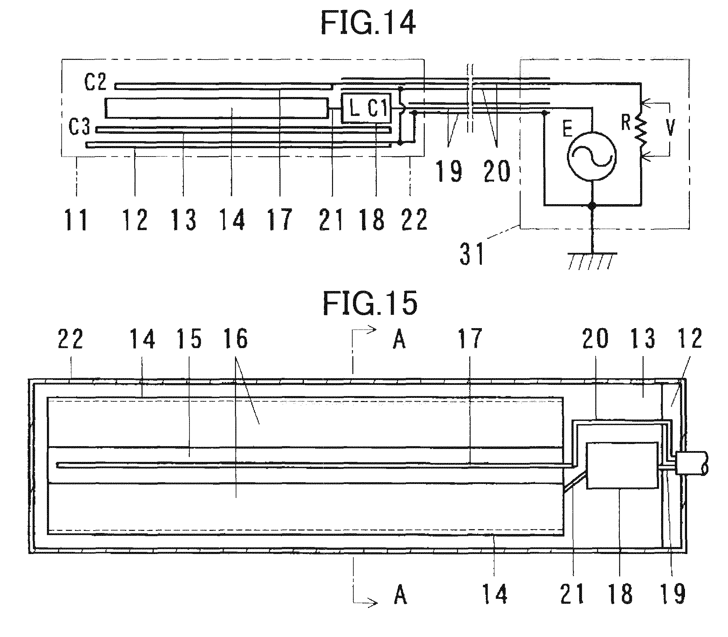

As shown in FIG 14, a sensing head 11 of the capacitive proximity sensor of an embodiment is equipped with multifaceted electrodes including a shield electrode. The sensing head 11 is connected to an electric circuit 31 through shielded cables 19 and 20.

As shown in FIG 14, 15 and 16, the sensing head 11 includes a shield electrode 12, an insulation sheet 13, a planar electrode 14, a linear electrode 17 and a coil 18.

The shield electrode 12 is a metal plate or sheet in a tape-like or rectangular shape. The insulation sheet 13 which is almost the same size and shape as the shield electrode 12 is placed parallel with the shield electrode 12 in the same way to the same extent lengthwise. The insulation sheet 13 works as an insulator in between the shield electrode 12 and the planar electrode 14. As shown in FIG. 8, the planar electrode 14 is a metal channel including a rear panel 15 and two front panels 16 on both sides. The rear panel 15, which is a flat plate or a sheet in a tape-like or rectangular shape, is slightly smaller than the shield electrode 12 and the insulation sheet 13. The planar electrode 14 is placed parallel with the insulation sheet 13 in the same way to the same extent lengthwise. The linear electrode 17, which is a metal bar or a wire, is placed parallel between the front panels 16 of the planar electrode 14 in the same way to the same extent lengthwise. The linear electrode 17 is separated from both of the front panels 16 at a same distance.

Both the coil 18, and terminals of the shielded cables 19 and 20 are placed at one end of the sensing head 11. The coil carries an inductance L and a wire winding capacitance C1. One terminal of the coil 18 is joined to the planar electrode 14 through a wire 21. The other terminal of the coil 18 is joined to a core wire of one of the shielded cable 19. The linear electrode 17 is joined to a core of the other shielded cable 20. Braids of both shielded cable 19 and 20 are commonly joined to the shield electrode 12.

The shield electrode 12, the insulation sheet 13, the planar electrode 14, the linear electrode 17, the coil 18, the wire 21, and the terminals of the shielded cables 19 and 20 are fixed in a case 22 of synthetic resin by molding. All of them are placed in a mold which is fulfilled with the synthetic resin in liquid. After the synthetic resin hardens, the resin encloses them as the case 22 of an insulator. The case 22 may be formed in a tape-like or rectangular shape. A front side of the case 22 is where the linear electrode 17 appears over the planar electrode 14. The front detection region is at the front side. A rear side of the case 22 is where the linear electrode 17 hides behind the planar electrode 14.

The planar electrode 14 and the linear electrode 17 configure a capacitor C2. The planar electrode 14 and the shield electrode 12 configure a capacitor C3. The shield electrode 12, the planar electrode 14, the linear electrode 17, the coil 18 and the wire 21 are embedded and fixed in the case 22. If their mutual positions or distances change even a little, capacitances or inductances among them vary then LC series resonant characteristics are diverted. Fixation of all of them together maintains capacitances and inductances among them not to change.

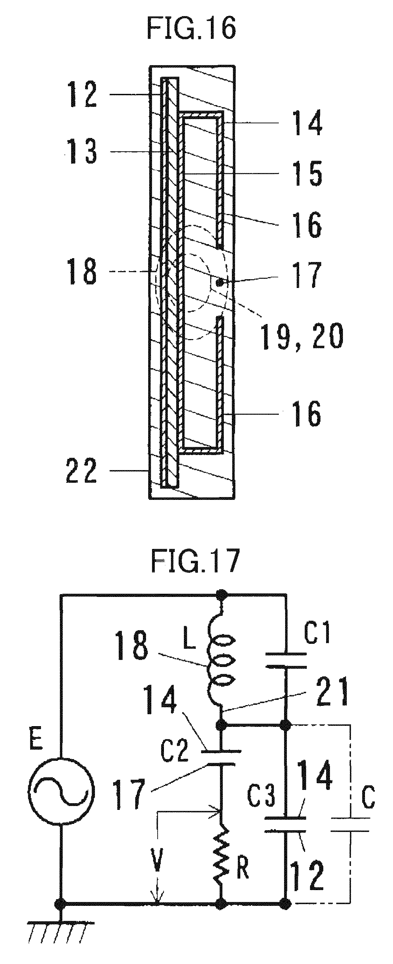

An electrical circuit unit 31 includes an oscillator E, a resistor R, a circuit block detecting a change of a voltage V between both terminals of the resistor R, and the other terminals of the shielded cables 19 and 20. One terminal of the oscillator E and one terminal of the resistor R are joined together and grounded. The other terminal of the oscillator E is joined to a core wire of the shielded cable 19. The other terminal of the resistor R is joined to a core wire of the shielded cable 20. The braids of both shielded cables 19 and 20 are grounded as well. The electrical circuit involving the electrical circuit unit 31 is shown in FIG. 17. To operate the series resonant circuit, the coil 18 carrying inductance L is coupled to the planar electrode 14, which constitutes the capacitor C2 with the linear electrode 17. This series connection is same as the LC series resonant circuit shown in FIG. 9. An oscillating frequency of the oscillator E is set to the frequency insensitive to deposition of raindrops, which is a little higher than the series resonant frequency.

The front detection region in front of the case 22, gives a long detection range with a human body. It is about 200 mm. The rear detection region in rear of the case 22 hardly gives any detection with the human body. Raindrops or so even attach to a front face of the case 22 are never detected.

### [Alternative embodiments]

1) The linear electrode 17 of the embodiment mentioned above is round shape at a cross section. The linear electrode 17 is possible to be square shape.
2) The planar electrode 14 of the embodiment mentioned above is a channel that a flat plate or a sheet is folded or bent. It is also able to be the channel as shown in FIG. 11, the two sheets of flat panels as shown in FIG. 10, or one sheet of the flat panel as shown in FIG. 7.

### Industrial Applicability

The present invention is applied to prevent a human body from approaching to or collision against a mobile object, entering into hazardous places, or accessing to restricted area, or applied to verify existence of a human body.

### Reference Signs List

- 1: a linear electrode, an electric wire
- 2: a planar electrode, a flat metal plate or sheet
- 3, 4: a planar electrode, a metal channel bending a plate or a sheet
- 3: a rear panel of the planar electrode
- 4: two front panels of a planar electrode
- 4, 5: a planar electrode, a metal channel folding a plate or a sheet
- 5: a groove panel of a planar electrode
- 6: an electrode
- 7: an electrode
- 8: a shield electrode, a flat metal plate or sheet
- 11: a sensing head
- 12: a shield electrode, a flat metal plate or sheet
- 13: an insulation sheet, insulator
- 14: a planar electrode, a metal channel bending a plate or a sheet
- 15: a rear panel of a planar electrode
- 16: two front panels of a planar electrode
- 17: a linear electrode, a metal rod or wire, or an electric wire
- 18: a coil
- 19, 20: a cable, a shielded cable
- 19: a shielded cable
- 20: a shielded cable
- 21: a wire
- 22: a case, molded with an synthetic resin of an electric insulator
- 31: an electrical circuit unit
- E: an oscillator
- L: a coil, an inductance
- C1: a wire winding capacitance of the coil
- C2: a capacitor formed with the electrodes
- C3: a capacitor formed with the shield electrode
- C: a capacitor formed by a human body
- R: a resistor
- V: a voltage, a voltage measured

## Claims

1. A capacitive proximity sensor that detects an object such as a human body or so approaching to the sensor by a change of capacitance formed by between a first electrode and a second electrode, comprising:
the first electrode being in a linear shape at a small surface area, and the second electrode being in a planar shape at a large surface area;
the first linear electrode and the second planar electrode arranged in parallel at a separation; and
a front detection region in front of the sensor being at a side where the first linear electrode appears upon the second planar electrode.

2. The capacitive proximity sensor according to claim 1, wherein the linear electrode is an electric wire; and
the planar electrode is a flat plate, a folded profile folding a flat plate or a bent profile bending a flat plate.

3. The capacitive proximity sensor according to claim 1 or 2, comprising a shield electrode facing to the planar electrode in parallel at a separation behind the planar electrode, and the shield electrode is grounded.

4. The capacitive proximity sensor according to claim 1, 2 or 3, comprising an electrical circuit including the capacitor composed of the linear electrode and the planar electrode, wherein the electric circuit changes a voltage or a current at a part of the circuit when the object approaches to the detecting region in front of the capacitive proximity sensor, and the voltage or the current is detected.

5. The capacitive proximity sensor according to claim 1, 2, 3 or 4 wherein the capacitor composed of the linear electrode and the planar electrode, a coil connected to the planar electrode, a resistor and an oscillator are connected to comprise a series resonant circuit;
a voltage of the resistor at both ends or a current through the series resonant circuit is detected; and
an oscillating frequency of the oscillator is set to a frequency, which is higher than a series resonant frequency, where the voltage or the current drops by decrease of the series resonant frequency when the object approaches to the detecting region in front of the capacitive proximity sensor, but the voltage or the current does not change or undergoes very little change by decrease of an impedance along with decrease of the series resonant frequency when non-detection objects such as raindrops etc. approach closely to the capacitive proximity sensor.
